# FASCICULE DE BREVET EUROPEEN

(11) **EP 3 985 401 B1**
(45) Date de publication et mention de la délivrance du brevet: **23.08.2023**
(21) Numéro de dépôt: 21202809.6
(22) Date de dépôt: 15.10.2021
(51) Int. Cl.: G01R 19/155

(54) **DISPOSITIF DE DÉTECTION DE PRÉSENCE DE TENSION ET TABLEAU ÉLECTRIQUE COMPRENANT UN TEL DISPOSITIF**
VORRICHTUNG ZUR ERKENNUNG DER PRÄSENZ VON ELEKTRISCHER SPANNUNG UND ELEKTRISCHE SCHALTTAFEL, DIE EINE SOLCHE VORRICHTUNG UMFASST
DEVICE FOR DETECTING THE PRESENCE OF VOLTAGE AND ELECTRICAL SWITCHBOARD COMPRISING SUCH A DEVICE

(30) Priorité: 16.10.2020 FR 2010616
(43) Date de publication de la demande: 20.04.2022
(73) Titulaire: Schneider Electric Industries SAS, 92500 Rueil-Malmaison (FR)
(72) Inventeur: BARGUES, Elodie, 38250 VILLARD DE LANS (FR); BADIN, Didier, 38400 SAINT MARTIN D'HÈRES (FR); DARURU, Bharath, 560067 BANGALORE (IN); MALLYA, Shreyus, 560041 BENGALURU (IN)
(74) Mandataire: Lavoix

(56) Documents cités:
- EP-A1- 3 419 040
- WO-A2-2012/007831
- JP-A- 2012 122 849
- US-A1- 2015 241 480
- US-A1- 2016 322 804
- US-A1- 2018 012 719
- US-A1- 2020 292 599

## Description

La présente invention concerne un dispositif de détection de présence de tension et un tableau électrique comprenant un tel dispositif.

Un tableau électrique est un tableau de répartition de l'énergie électrique, provenant d'une ou plusieurs lignes d'alimentation, vers une ou plusieurs charges électriques. Un tableau électrique est généralement placé dans une enceinte, tel qu'un boitier ou une armoire, qui délimite un espace de câblage dans lequel sont reçus divers appareils électriques destinés à la distribution et/ou au contrôle de l'énergie électrique. De manière non limitative, les appareils électriques sont par exemple un disjoncteur, un compteur d'énergie, un bornier de branchement, un porte-fusible, etc. Pour faciliter sa fabrication, le tableau électrique comprend généralement des rails de fixation, qui sont fixés à l'enceinte et sur lesquels sont montés certains des appareils électriques.

Une charge électrique est généralement connectée au tableau électrique par l'intermédiaire d'un bornier, qui est lui-même monté sur un rail du tableau électrique. À titre d'exemple, une charge électrique peut être un moteur électrique, une machine, un outil, un ordinateur, un réfrigérateur, etc.

Selon les applications, la charge électrique est une charge dite « critique », c'est-à-dire que cette charge électrique critique doit toujours être alimentée en énergie électrique. Par exemple, le réfrigérateur d'un restaurant doit toujours être alimenté en énergie électrique pour garantir la conservation des denrées alimentaires qui y sont stockées. Il convient donc de surveiller l'alimentation électrique de ces charges critiques.

US 2018/012719-A1, US-2016/322804-A1, WO-2012/007831-A1, JP-2012 122849-A, US-2020/292599-A1 et US-2015/241480-A1 décrivent des dispositifs de connexion électrique de l'art antérieur.

Il est connu, notamment de EP-3 419 040-A1, de brancher un dispositif de supervision à la connexion électrique entre la charge électrique critique et le bornier correspondant, afin de mesurer des grandeurs électriques relatives à cette charge électrique, et ainsi s'assurer d'une certaine consommation d'énergie confirmant l'alimentation de ces charges. La mise en place d'un tel dispositif de supervision nécessite cependant des opérations de branchement supplémentaires, ce qui demande du temps. Le dispositif de mesure prend en outre de la place au sein du tableau électrique entre les rangées d'appareillages et diminue l'espace de câblage.

C'est à ces problèmes qu'entend plus particulièrement remédier l'invention, en proposant un dispositif qui permette de confirmer l'alimentation électrique de charges électriques alimentées électriquement par un tableau électrique, qui soit plus pratique à installer et qui soit peu encombrant lorsqu'il équipe ce tableau électrique.

À cet effet, l'invention concerne un dispositif de détection de présence de tension pour un tableau électrique, le dispositif de détection de présence de tension étant selon la revendication 1.

Grâce à l'invention, le dispositif de détection de présence de tension est monté directement sur un rail du tableau électrique et relie la ligne d'alimentation à la charge électrique. Le dispositif de détection de présence de tension permet ainsi de remplacer un bornier, et ne représente pas d'encombrement supplémentaire au sein du tableau électrique. En outre, le dispositif de détection de présence de tension ne demande pas de branchement spécifique pour surveiller l'alimentation de la charge critique, ce qui est une source de gain de temps lors du montage du dispositif de détection de présence de tension.

Selon des aspects avantageux non obligatoires de l'invention, un tel dispositif de détection de présence de tension peut incorporer une ou plusieurs des caractéristiques suivantes prises isolément ou selon toute combinaison techniquement admissible :
- Le corps comprend plusieurs tranches, qui sont assemblées en étant superposées suivant un axe transversal perpendiculaire à l'axe de profondeur et à l'axe de hauteur, chaque tranche logeant l'une des bornes d'entrée, la borne de sortie à laquelle la borne d'entrée est électriquement connectée, et le membre conducteur connectant électriquement ladite borne d'entrée à ladite borne de sortie.
- Le conduit, la branche supérieure et la branche inférieure délimitent un logement, qui débouche en façade, et dans lequel le module de détection de présence de tension est reçu au moins en partie dans le logement, de sorte que la branche supérieure, le module de détection de présence de tension et la branche inférieure sont successivement répartis le long de l'axe de hauteur, le module de détection de présence de tension et la portion de fixation étant disposés de part et d'autre du conduit.
- Le module de détection de présence de tension est fixé sur la façade.
- Le capteur est un capteur de tension, configuré pour détecter une tension électrique entre les pôles d'alimentation, par l'intermédiaire des membres conducteurs.
- Le capteur et le dispositif de communication sont configurés pour être alimentés en énergie électrique par l'intermédiaire des membres conducteurs.
- Le dispositif de communication comprend un émetteur radiofréquences, configuré pour envoyer une information reflétant la détection de la tension électrique effectuée par le capteur à un récepteur radiofréquences de la passerelle.
- Le dispositif de détection de présence de tension comprend en outre au moins une carte de circuit imprimé, le capteur et le dispositif de communication étant formés par un ou plusieurs composants électroniques disposés sur ladite au moins une carte de circuit imprimé.

L'invention concerne aussi un tableau électrique comprenant :
- le dispositif de détection de présence de tension tel que décrit précédemment ;
- le rail, sur lequel le dispositif de détection de présence de tension est fixé au moyen de la portion de fixation ;
- les pôles d'alimentation, auxquels les bornes d'entrées sont respectivement connectées ;
- les pôles de charge auxquels les bornes de sortie sont respectivement connectées.

Avantageusement, le tableau électrique comprend en outre la passerelle.

L'invention sera mieux comprise, et d'autres avantages de celle-ci apparaîtront plus clairement à la lumière de la description qui va suivre, de trois modes de réalisation d'un dispositif de détection de présence de tension et d'un tableau électrique conforme à son principe, donnés uniquement à titre d'exemple et faits en référence aux dessins annexés, dans lesquels :
- [Fig 1] la figure 1 est une vue en perspective d'un tableau électrique selon l'invention, qui comprend des dispositifs de détection de présence de tension conformes à un premier mode et à un deuxième mode de réalisation de l'invention ;
- [Fig 2] la figure 2 est une vue du détail II de la figure 1, représentant un dispositif de détection conforme au premier mode de réalisation de l'invention ;
- [Fig 3] la figure 3 est une vue en perspective partiellement éclatée du dispositif de détection de la figure 2 ;
- [Fig 4] la figure 4 est une vue en perspective éclatée du dispositif de détection de la figure 2, certains éléments étant omis pour faciliter la lecture ;
- [Fig 5] la figure 5 est une vue du détail V de la figure 1, représentant un dispositif de détection conforme au deuxième mode de réalisation de l'invention ;
- [Fig 6] la figure 6 est une vue en perspective éclatée du dispositif de détection de la figure 5, certains éléments étant omis pour faciliter la lecture ;
- [Fig 7] la figure 7 est une vue en perspective d'un dispositif de détection conforme à un troisième mode de réalisation de l'invention, et
- [Fig 8] la figure 8 est une coupe, suivant un plan VIII sur la figure 7, du dispositif de détection de la figure 7.

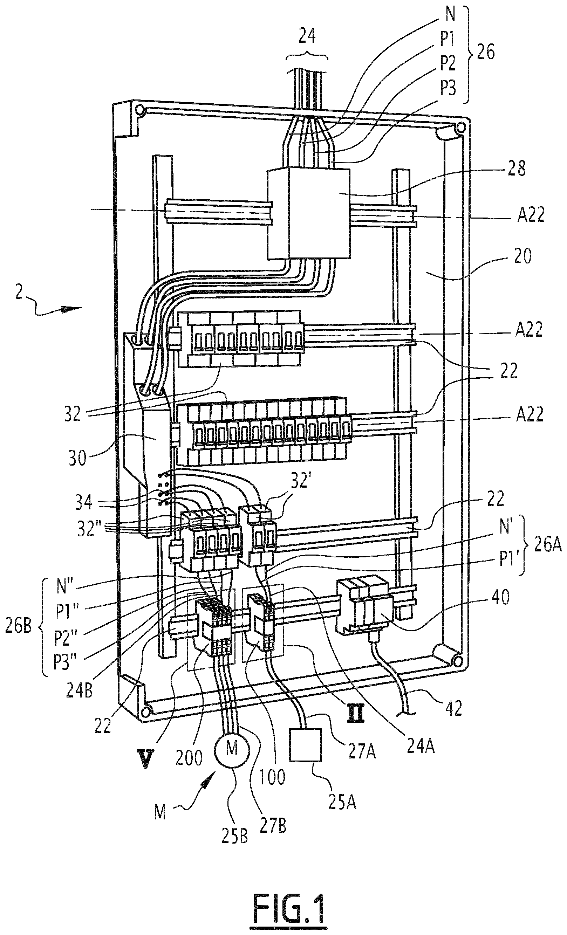

La figure 1 représente un tableau électrique 2. Le tableau électrique 2 est ici reçu dans un boîtier de forme parallélépipédique, dans lequel sont logés divers appareils électriques. Le tableau électrique comprend un fond 20, qui est ici de forme rectangulaire et qui est situé dans un plan vertical. Bien entendu, d'autres orientations sont possibles, la description qui suit étant faite relativement à l'orientation du tableau électrique 2 et des autres appareils sur les dessins, et ne préjugeant pas de l'orientation du tableau électrique 2 dans la réalité.

Le tableau électrique 2 comprend des rails 22, qui sont ici fixés au fond 20 et qui sont ici disposés horizontalement, parallèlement les uns aux autres. Chaque rail 22 est réalisé en métal, de préférence en acier, et présente une forme allongée s'étendant suivant un axe de rail A22 respectif. Les rails 22 présentent avantageusement un profil similaire, et fonctionnent de la même façon. Dans l'exemple illustré, les rails 22 sont identiques les uns aux autres, chaque rail 22 présentant un profil en forme de Ω - oméga -. Selon des exemples, les rails 22 présentent un profil normalisé, par exemple un profil « DIN ». D'autres profils de rails 22 sont bien entendu possibles.

Le tableau électrique 2 permet de distribuer l'énergie électrique provenant d'une ou plusieurs lignes d'alimentation vers une ou plusieurs charges électriques. Dans l'exemple illustré, une seule ligne d'alimentation 24 est représentée, et deux charges électriques 25A et 25B sont schématiquement représentées. La ligne d'alimentation 24 comprend plusieurs pôles d'alimentation 26. Dans l'exemple illustré, la ligne d'alimentation 24 est une ligne triphasée, qui comprend quatre pôles d'alimentation 26, plus précisément un neutre N et trois phases référencées P1, P2 et P3. En variante non représentée, la ligne d'alimentation est une ligne dite « monophasée », qui comprend seulement deux pôles d'alimentation 26, incluant un neutre N et une phase P1.

Selon le type de charge électrique, ces charges électriques doivent être connectées à une source d'énergie électrique monophasée ou bien triphasée. Le type de ligne d'alimentation 24 et de tableau électrique 2 sont bien entendu choisis en fonction de la ou des charges électriques à alimenter. Dans l'exemple illustré, une première charge 25A, telle qu'un réfrigérateur, comprend deux pôles de charge 27A et est connectée à une source d'énergie monophasée, tandis qu'une deuxième charge 25B, telle qu'un moteur, présente quatre pôles de charge 27B et est connectée à une source d'énergie triphasée.

Dans l'exemple illustré, la ligne d'alimentation 24 est reliée à un disjoncteur 28, qui est fixé sur l'un des rails 22. Le disjoncteur 28 est lui-même relié à un boîtier de distribution 30, qui présente ici une forme allongée, et qui est disposé dans sa longueur orthogonalement à l'axe longitudinale A22 des rails 22.

Le tableau électrique 2 comprend aussi des appareils électriques 32, 32' et 32", qui peuvent être, de manière non limitative, des disjoncteurs différentiels, des porte-fusibles, des minuteries, etc. Les appareils électriques 32, 32' et 32" sont ici montés sur des rails 22, les appareils 32' et 32" étant électriquement connectés au boîtier de distribution 30 par l'intermédiaires de fils électriques 34.

Le tableau électrique 2 comprend aussi des dispositifs de détection de présence de tension, qui sont chacun, d'une part, connectés électriquement à la ligne d'alimentation 24 et, d'autre part, connectés électriquement à une charge électrique. Dans le cadre de la présente description, un « dispositif de détection » fait référence à « un dispositif de détection de présence de tension ».

Dans l'exemple illustré, un premier dispositif de détection, référencé 100, est connecté aux pôles de charge 17A de la charge 25A. Le dispositif de détection 100 est configuré pour être connecté à deux pôles d'alimentation N' et P1'. Le dispositif de détection 100 correspond au premier mode de réalisation de l'invention.

Les pôles d'alimentation N' et P1' sont ici respectivement électriquement connectés au pôles N et P1 de la ligne d'alimentation 24 via le disjoncteur 28, le boitier de distribution 30 et les appareils électriques 32'. Ainsi, lorsque les appareils 32' et le disjoncteur 28 sont fermés, les potentiels électriques des pôles N' et P1' sont reliés respectivement aux potentiels électriques des pôles N et P1. Les pôles d'alimentation N' et P1' sont collectivement appelés pôles d'alimentation 26A et forment ensemble une ligne d'alimentation 24A, à laquelle le dispositif de détection 100 est relié. Le dispositif de détection 100 détecte ainsi la présence d'une tension électrique entre les pôles d'alimentation 26A de la ligne d'alimentation 24A, qui alimente en énergie électrique la charge électrique 25A.

Un deuxième dispositif de détection, référencé 200, est connecté aux pôles de charge 27B de la charge 25B et est configuré pour être connecté à quatre pôles d'alimentation, référencés N", P1", P2" et P3". Le dispositif de détection 200 correspond au deuxième mode de réalisation de l'invention.

Les pôles d'alimentation N", P1", P2" et P3" sont électriquement connectés aux pôles N, P1, P2 et P3 de la ligne d'alimentation 24 via le disjoncteur 28, le boitier de distribution 30 et les appareils électriques 32". Ainsi, lorsque les appareils électriques 32" et le disjoncteur 28 sont fermés, les potentiels électriques des pôles N", P1", P2" et P3" sont reliés respectivement aux potentiels électriques des pôles N, P1, P2 et P3. Les pôles d'alimentation N", P1", P2" et P3" sont collectivement appelés pôles d'alimentation 26B et forment ensemble une ligne d'alimentation 24B, à laquelle le dispositif de détection 200 est relié. Le dispositif de détection 200 détecte ainsi la présence d'une tension électrique entre les pôles d'alimentation 26B de la ligne d'alimentation 24B, qui alimente en énergie électrique la charge électrique 25B.

Le tableau électrique 2 comprend aussi une passerelle 40 - dite aussi « *gateway* » en anglais - configurée pour recevoir des informations transmises par le ou les dispositifs de détection 100 et/ou 200 et pour transmettre ces informations vers un réseau informatique 42, représenté ici par un câble réseau. Le réseau informatique 42 ne fait pas partie du tableau électrique 2 mais sert à préciser le contexte de fonctionnement des dispositifs de détection 100 et 200.

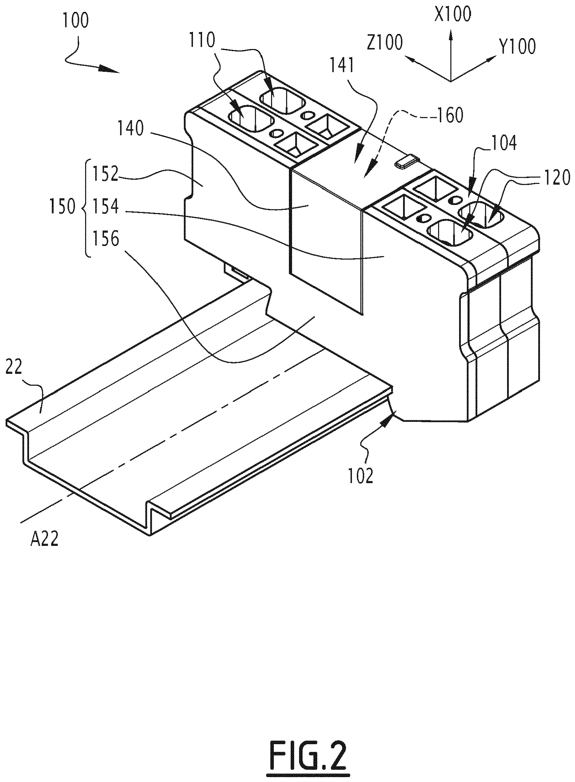

On décrit tout d'abord le dispositif de détection de présence de tension 100 conforme au premier mode de réalisation de l'invention, à l'aide des figures 2 à 4. Le dispositif de détection 100, représenté à plus grande échelle sur la figure 2, comprend une portion de fixation 102, qui permet de fixer le dispositif de détection 100 sur le rail 22. Le montage du dispositif de détection 100 sur le rail 22 se fait de préférence à la main et sans outil, par encliquetage de la portion de fixation 102 sur le rail 22.

Le dispositif de détection 100 est représenté monté sur un rail 22, dans une configuration dite « d'utilisation ». Lorsque le rail 22 est intégré dans un tableau électrique 2, tel que représenté sur la figure 1, la portion de fixation 102 est orientée vers le fond 20 du tableau électrique 2, et constitue ainsi un dos du dispositif de détection 100. Le dispositif de détection 100 définit aussi une façade 104, qui est orientée du côté opposé au dos, autrement dit qui est orientée vers un utilisateur lorsque ce dernier se tient devant le tableau électrique 2. Le dispositif de détection 100 définit ainsi un axe de profondeur X100, qui est orthogonal à la façade 104 et qui traverse la portion de fixation 102 et la façade 104. L'axe de profondeur X100 est ici orthogonal à l'axe de rail A22 en configuration d'utilisation du dispositif de détection 100.

Par commodité, on définit un axe transversal Y100 du dispositif de détection 100, l'axe transversal Y100 étant orthogonal à l'axe de profondeur X100. L'axe transversal Y100 est parallèle à l'axe de rail A22 en configuration d'utilisation du dispositif de détection 100. On définit aussi un axe de hauteur Z100, de manière que les axes X100, Y100 et Z100 forment un repère orthogonal. Dans la configuration d'utilisation illustrée sur la figure 1, l'axe transversal Y100 est donc horizontal, l'axe de profondeur X100 est orthogonal au fond 20 du tableau électrique 2 et l'axe de hauteur Z100 est vertical.

Le dispositif de détection 100 comprend des bornes d'entrée 110 et des bornes de sortie 120. Chaque borne de sortie 120 est configurée pour être électriquement connectée à un pôle de charge 27A respectif de la charge électrique 25A. Le dispositif de détection 100 est donc configuré pour être connecté à une charge électrique 25A monophasée, comprenant deux pôles de charge 27A, avec un neutre et une phase.

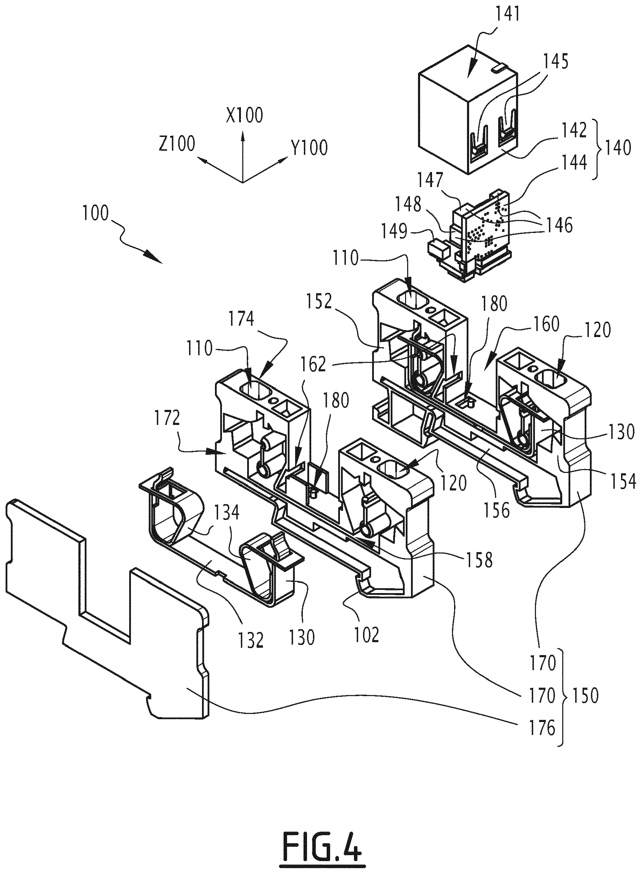

Chaque borne d'entrée 110 est configurée pour être électriquement connectée à un pôle d'alimentation 26A respectif de la ligne d'alimentation 24A. On comprend qu'à chaque borne de sortie 120 correspond une unique borne d'entrée 110, chaque borne de sortie 120 étant électriquement connectée à l'une des bornes d'entrée 110 par l'intermédiaire d'un membre conducteur 130. Les membres conducteurs 130 sont mieux visibles sur la perspective éclatée de la figure 4. Dans l'exemple illustré, chaque membre 130 comprend une lame métallique 132 en forme de U, et deux ressorts 134, configurés pour être actionnés à l'aide d'un outil, tel qu'un tournevis, afin de bloquer ou de libérer une extrémité d'un fil électrique de l'un des pôles d'alimentation 26A ou de l'un des pôles de charge 27A.

Lorsque le dispositif de détection 100 est en configuration d'utilisation, les bornes d'entrée 110 sont situées au-dessus des bornes de sortie 120, les bornes d'entrée 110 et les bornes de sortie 120 étant ici alignées suivant l'axe de hauteur Z100.

Le dispositif de détection 100 comprend un module de détection 140, configuré pour détecter une présence de tension électrique associée aux pôles d'alimentation 26A, et un corps 150. Autrement dit, le module de détection 140 est un module de détection de présence de tension.

Le corps 150 est réalisé en un matériau isolant, par exemple en polymère synthétique tel que du polyamide - noté aussi PA -. Le corps 150 comprend une branche supérieure 152, qui loge les bornes d'entrée 110, une branche inférieure 154, qui est distante de la branche supérieure 152 et qui loge les bornes de sortie 120, et un conduit 156, qui relie la branche supérieure 152 et la branche inférieure 154. Des passages 158 sont ménagés à l'intérieur du conduit 156, les membres conducteurs 130 étant logés à l'intérieur des passages 158 et connectant électriquement les bornes d'entrée 110 aux bornes de sortie 120 en traversant le conduit 156. Chaque membre conducteur 130 est de préférence reçu dans un passage 158 respectif, pour limiter les risques de court-circuit entre les membres conducteurs 130.

Dans l'exemple illustré, les branches supérieures 152 et inférieures 154 présentent chacune une forme allongée qui s'étant parallèlement à l'axe X100, tandis que le conduit 156 présente une forme allongée qui s'étend parallèlement à l'axe de hauteur Z100. Le conduit 156, la branche supérieure 152 et la branche inférieure 154 délimitent ensemble un logement 160 du corps 150.

Dans le premier mode de réalisation de l'invention, le module de détection 140 est reçu, au moins en partie, dans le logement 160. Ainsi la branche supérieure 152, le module de détection 140 et la branche inférieure 154 sont successivement répartis le long de l'axe de hauteur Z100. Le logement 160 est situé du côté opposé de la portion de fixation 102 par rapport au conduit 156 et débouche de la façade 104, ainsi le module de détection 140 et la portion de fixation 102 sont disposés de part et d'autre du conduit 156 et sont alignés suivant l'axe de profondeur X100.

Le module de détection 140 présente ici une forme de parallélépipède avec une face supérieure 141, qui est orthogonale à l'axe de profondeur X100 et orientée à l'opposé du conduit 156. La face supérieure 141 est ici située dans un même plan géométrique que la façade 104. Le module de détection 140 est ainsi intégré au reste du dispositif de détection 100, qui est peu encombrant et pratique à installer. En configuration d'utilisation du dispositif de détection 100, la face supérieure 141 est visible d'un utilisateur se tenant devant le tableau 2.

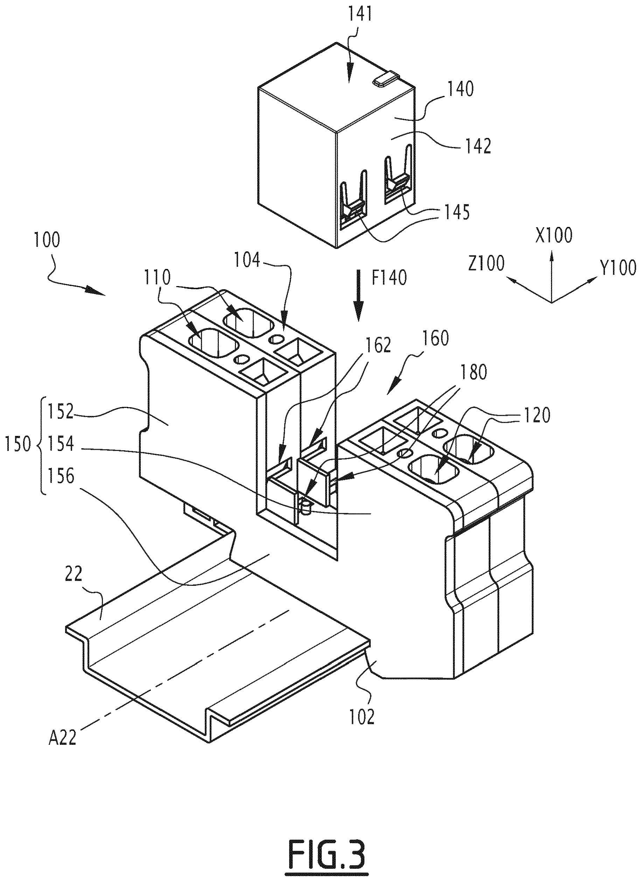

Le corps 150 est avantageusement un corps modulaire, c'est-à-dire que le corps 150 comprend plusieurs tranches 170, qui sont assemblées en étant superposées suivant l'axe transversal Y100. Le corps 150 est représenté assemblé sur les figures 2 et 3 et est représenté en vue éclatée sur la figure 4.

Les tranches 170 présentent avantageusement la même structure, et fonctionnent de la même façon. Optionnellement, l'une des tranches 170 du corps 150 présente une couleur différente de celle des autres, par exemple pour identifier celle des bornes d'entrée 110 devant être connectée au pôle neutre N' de la ligne d'alimentation 24A.

Chaque tranche 170 comprend ainsi une branche supérieure 152, une branche inférieure 154 et un conduit 156, chaque tranche 170 présentant ainsi une forme de U. Chaque tranche 170 loge l'une des bornes d'entrée 110, la borne de sortie 120 correspondante à laquelle cette borne d'entrée 110 est électriquement connectée, et le membre conducteur 130 connectant électriquement cette borne d'entrée 110 à la borne de sortie 120 correspondante.

Le dispositif de détection 100 selon le premier mode de réalisation comportant deux bornes d'entrée 110, le corps 150 comprend deux tranches 170. Chacune des tranches 170 présente deux faces latérales opposées et orientées orthogonalement à l'axe transversal Y100, avec une face ouverte 172, d'où débouche le passage 158, et une face fermée 174, opposée à la face ouverte 172. Ainsi, lorsque deux tranches 170 sont superposées suivant l'axe transversal Y100, la face ouverte 172 de l'une des tranches 170 est obturée par la face fermée 174 de l'autre tranche 170.

Le corps 150 comprend enfin un flasque latéral 176, qui obture la face ouverte 172 de la tranche 170 située entre l'autre tranche 170 et le flasque latéral 176. De préférence, les tranches 170 et le flasque latéral 176 sont produits individuellement, par exemple par injection à chaud, puis assemblés.

Chaque passage 158 débouche du corps 150 par l'intermédiaire d'un orifice 180 respectif, qui est ménagé dans le conduit 156 de chacune des tranches 170 et qui s'étend parallèlement à l'axe de profondeur X100. Dans le premier mode de réalisation de l'invention, chaque orifice 180 débouche ainsi de la façade 104, par l'intermédiaire du logement 160. Lorsque le module de détection 140 est manquant, chaque membre conducteur 130 logé dans le passage 158 correspondant est ainsi accessible depuis la façade 104. Dans l'exemple illustré, chaque orifice 180 débouche du corps 150 entre les bornes d'entrée 110 et les bornes de sortie 120, et chaque membre conducteur 130, reçu dans un passage 158 correspondant, est visible depuis le logement 160 parallèlement à l'axe de profondeur X100.

Le module de détection 140 comprend ici un boîtier 142 dans lequel est reçue une carte de circuit imprimé 144.

Le boitier 142 est réalisé en un matériau isolant, par exemple en matière polymère synthétique, et présente ici une forme de parallélépipède. Lors de la fabrication du dispositif de détection 100, le module de détection 140 est assemblé au corps par un mouvement de translation, repéré par la une flèche F140 sur la figure 3, orientée parallèlement à l'axe X100. Le boitier 142 comprend des ergots 145, qui coopèrent avec des renfoncements 162 ménagés dans les branches supérieure 152 et inférieure 154 de manière à maintenir le module de détection 140 en position assemblée dans le logement 160, tel que représenté sur la figure 2. L'assemblage du module de détection 140 avec le corps 150 se fait avantageusement sans outil par encliquetage des ergots 145 dans les renfoncements 162, tandis qu'une fois assemblé, le boitier 142 ne peut être désassemblé du corps 150, à moins par exemple d'endommager les ergots 145.

La carte de circuit imprimé 144 comprend un ou plusieurs composants électroniques 146, qui sont ici représentés schématiquement par des parallélépipèdes. Un ou plusieurs des composants électroniques 146 comprennent un capteur 147, configuré pour détecter la présence de tension, et un dispositif de communication 148, configuré pour envoyer une information reflétant la présence de tension détectée par le capteur 147 à la passerelle 40 de communication vers le réseau informatique 42.

Lorsque le module de détection 140 est reçu dans le logement 160, le capteur 147 est électriquement relié à chacun des membres conducteurs 130 par l'intermédiaire des orifices 180. Lorsque les bornes d'entrée 110 sont reliées aux pôles d'alimentation 26A de la ligne d'alimentation 24A, le capteur 147 est configuré pour détecter la présence de tension associée aux pôles d'alimentation 26A.

Le capteur 147 et le dispositif de communication 148 sont avantageusement alimentés en énergie électrique par l'intermédiaire des membres conducteurs 130 auxquels le capteur 147 est relié, les membres conducteurs 130 étant eux-mêmes connectés aux pôles d'alimentation 26A de la ligne d'alimentation 24A. Ainsi, le module de détection 140 est autonome en énergie, c'est-à-dire qu'il ne nécessite pas, pour fonctionner, de connexion spécifique vers une alimentation extérieure autre que la connexion aux membres conducteurs 130. Autrement dit, le ou les dispositifs de détection 100 peuvent être disposés, au sein du tableau électrique 2, sans contrainte de placement en lien avec leur alimentation en énergie électrique. En résultat, la mise en place du dispositif de détection 100 dans le tableau électrique 2 est particulièrement pratique et rapide.

Optionnellement, le module de détection 140 comprend un accumulateur d'énergie, par exemple la carte 144 comprend un condensateur, configuré pour accumuler de l'énergie électrique lorsque la tension électrique entre les pôles d'alimentation 26A n'est pas nulle et pour alimenter les composants électronique 146 du module de détection 140 en énergie électrique lorsque la tension électrique entre les pôles d'alimentation 26A est nulle. Bien entendu, si besoin le module de détection 140 peut inclure une batterie interne, telle qu'une pile, pour son fonctionnement.

Dans l'exemple illustré, le capteur 147 est un capteur de tension, configuré pour détecter une tension électrique entre les pôles d'alimentation 26A, par l'intermédiaire des membres conducteurs 130. Plusieurs technologies de capteur 147 existent, qui sont sélectionnés en fonction notamment des tensions considérées, de la précision recherchée, de leur coût, des contraintes d'utilisation, etc. À titre d'exemple non limitatif, le capteur 147 est un diviseur résistif.

Ainsi, lorsque les capteurs 147 détectent un état électrique anormal entre les pôles d'alimentation 26A, par exemple lorsque les capteurs 147 détectent une absence de tension entre les pôles d'alimentation 26A, le dispositif détection 100 envoie à la passerelle 40 une information relative à cette absence de tension, puis la passerelle 40 relaie cette information vers le réseau informatique 42. Cette information peut être relayée par exemple sous la forme d'un courriel envoyé à un utilisateur.

Avantageusement, le dispositif de communication 148 comprend un émetteur radiofréquence 149, configuré pour envoyer l'information reflétant l'absence de tension du capteur 147 à un récepteur radiofréquence de la passerelle 40. Le récepteur radiofréquence n'est pas représenté. L'émetteur radiofréquence 149 est avantageusement intégré à la carte de circuit imprimé 144. Il n'est ainsi pas nécessaire de connecter physiquement le dispositif de détection 100 à la passerelle 40, par exemple au moyen d'un câble. Autrement dit, le ou les dispositifs de détection 100 peuvent être disposés, au sein du tableau électrique 2, sans contrainte de placement en lien avec la passerelle 40. Selon des exemples, l'émetteur radiofréquence 149 et le récepteur radiofréquence communiquent selon un protocole conforme à une norme IEEE 802.15.4, en particulier selon un protocole dit « *Zigbee* ».

Avantageusement, le boîtier 142 du module de détection 140 est réalisé en matière plastique translucide, tandis que la carte de circuit imprimé 144 comprend un dispositif lumineux, non représenté, configuré pour transmettre à l'utilisateur un signal visuel sur les informations du capteur 147. Par exemple, le dispositif lumineux comprend une ou plusieurs diodes électroluminescentes - dites aussi LED -, dont l'état d'allumage change selon qu'une tension électrique entre les pôles d'alimentation 26A est détectée ou non. Dans l'exemple illustré, le module de détection 140 comprend une LED, qui est visible au travers de la face supérieure 141 et qui s'éteint lorsque la tension entre les pôles d'alimentation 26A est nulle.

Le dispositif de détection 100 selon l'invention permet donc, de manière pratique, de surveiller la tension entre les pôles d'alimentation 26A reliés aux pôles de charge 27A de à la charge électrique 25A par l'intermédiaire des bornes de sortie 120, sans avoir à connecter de capteur spécifique ou de fil d'alimentation. D'autre part, le capteur 147 et le dispositif de communication 148 sont intégrés sur la carte de circuit imprimé 144, leur fabrication est ainsi particulièrement bon marché. Enfin, le dispositif de communication 148 intégrant avantageusement un émetteur radiofréquence 149, le dispositif de détection 100 peut être disposé au sein du tableau électrique 2 en se libérant des contraintes liées à la connexion avec la passerelle 40.

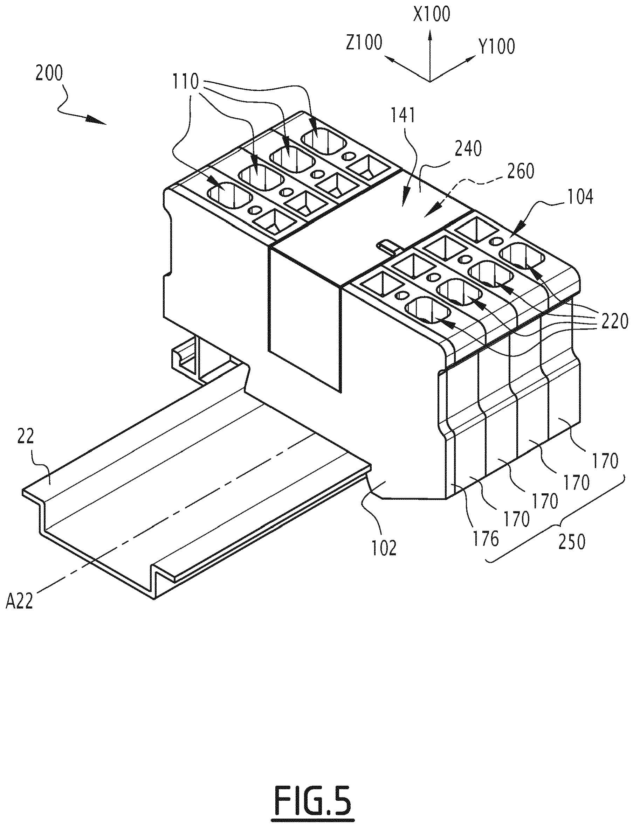

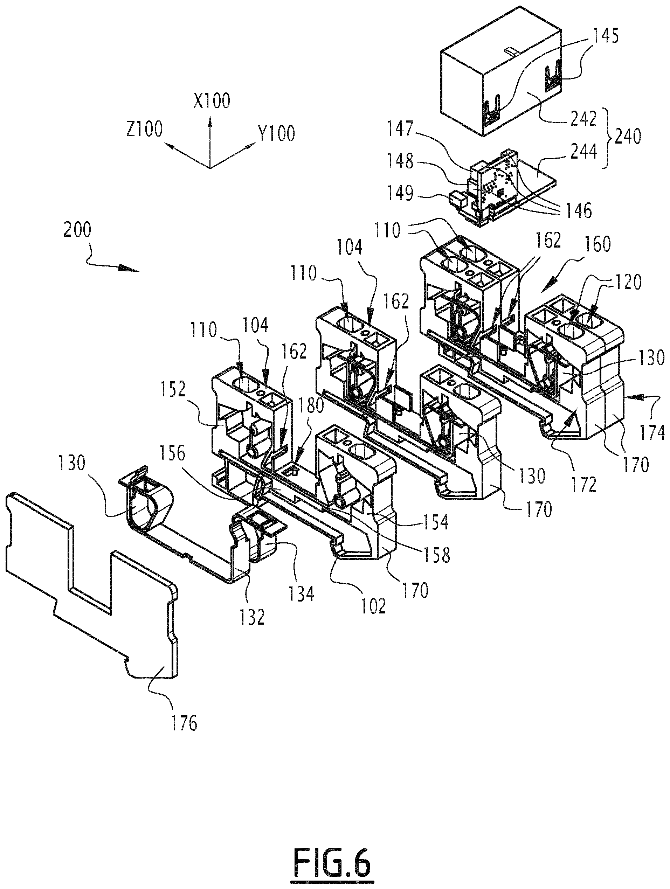

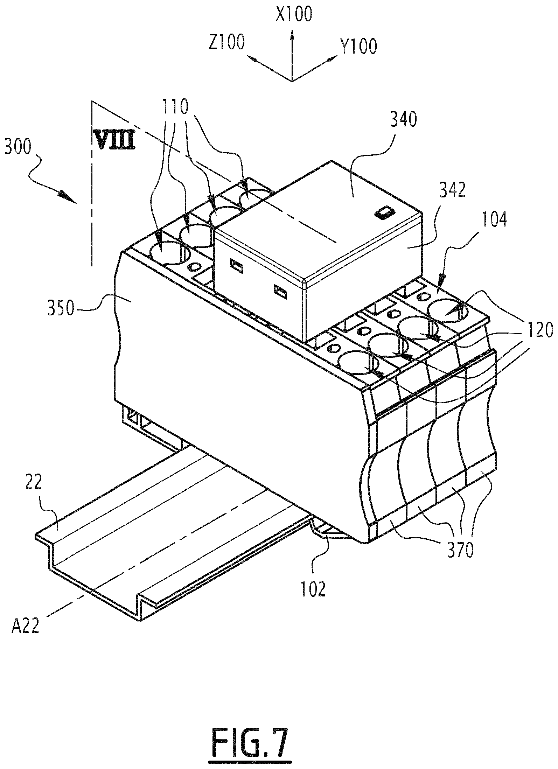

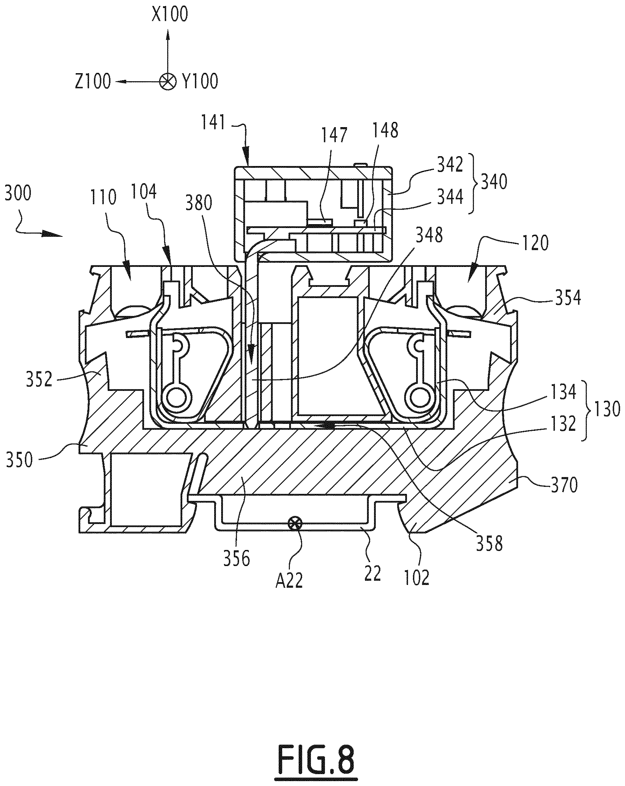

Le dispositif de détection de présence de tension 200, conforme au deuxième mode de réalisation, est représenté plus en détail sur les figures 5 et 6, tandis qu'un dispositif de détection de présence de tension 300, conforme à un troisième mode de réalisation, est représenté sur les figures 7 et 8. Dans les nouveaux modes de réalisation, les éléments analogues à ceux des modes de réalisation précédents portent les mêmes références et fonctionnent de la même façon. Dans ce qui suit, on décrit principalement les différences entre les nouveaux modes de réalisation et les modes précédents.

Le dispositif de détection 200 est identique au dispositif de détection 100 sauf pour les différences discutées ci-après. Une des principales différences entre le dispositif de détection 200 du deuxième mode de réalisation et le dispositif de détection 100 du premier mode est que le dispositif de détection 200 comprend un corps 250 qui est modulaire et qui comprend quatre tranches 170, qui sont assemblées les unes aux autres en étant superposées suivant l'axe transversal Y100. Chaque tranche 170 du dispositif de détection 200 loge l'une des bornes d'entrée 110, la borne de sortie 120 à laquelle cette borne d'entrée 110 est électriquement connectée, et le membre conducteur 130 connectant électriquement ladite borne d'entrée 110 à ladite borne de sortie 120.

Le dispositif de détection 200 comprend donc quatre bornes d'entrée 110, chacune configurée pour être électriquement connectée à un pôle d'alimentation 26B de la ligne d'alimentation 24B, et quatre bornes de sortie 120, chacune configurée pour être électriquement connectée à un pôle de charge 27B respectif de la charge électrique 25B. Le dispositif de détection 200 est donc configuré pour être connecté à une charge électrique fonctionnant en triphasé, c'est-à-dire comprenant un pôle de charge neutre N" et trois phases P1", P2" et P3".

Le dispositif de détection 200 est représenté, sur la figure 5, monté sur un rail 22 par l'intermédiaire de la portion de fixation 102, situé au dos du dispositif de détection de présence de tension 200.

Les quatre tranches 170 du corps 250 comprennent chacune une branche supérieure 152, une branche inférieure 154 et un conduit 156, qui relie la branche supérieure 152 à la branche inférieure 154. Le conduit 156, la branche supérieure 152 et la branche inférieure 154 de chacune des tranches 170 délimite un logement 260, qui loge un module de détection de présence de tension 240. Le module de détection 240 du deuxième mode de réalisation fonctionne de la même façon que le module de détection 140 du premier mode, les dimensions du module de détection 240 étant bien entendu adaptées au logement 260. Ainsi, le capteur 147 du module de détection 240 est électriquement relié à chacun des membres conducteurs 130 par l'intermédiaire des orifices 180. De façon symétrique, lorsque le dispositif de détection 200 est entièrement assemblé, c'est-à-dire que les tranches 170 sont superposées les unes sur les autres suivant l'axe transversal Y100 et le flasque latéral 176 est lui-aussi mis en place, alors que le module de détection 240 est reçu dans le logement 260, tel que représenté sur la figure 5, alors les membres conducteurs 130 ne sont pas accessibles, depuis l'extérieur, autrement que par les bornes d'entrée 110 ou par les bornes de sortie 120.

Les tranches 170 et le flasque latéral 172 du dispositif de détection 200 du deuxième mode de réalisation sont respectivement identiques aux tranches 170 et au flasque 172 du dispositif de détection 100 du premier mode de réalisation. Les mêmes outils de production sont ainsi utilisés pour fabriquer les corps 150 ou 250 des dispositifs de détection 100 ou 200, configurés pour être respectivement connectés à une ligne d'alimentation 24A monophasée ou 24B triphasée, ce qui est économique. Seul le module de détection 140 ou 240 présente structure spécifique, adaptée à la taille du logement 160 ou 260 et adaptés aux connexions aux deux ou quatre membres conducteurs 130 par les orifices 180.

Le dispositif de détection 300 est identique au dispositif de détection 200 sauf pour les différences discutées ci-après. Une des principales différences entre le dispositif de détection de présence de tension 300, conforme au troisième mode de réalisation de l'invention, et les modes de réalisation précédents, est que dans les modes précédents, le corps 150 ou 350 comprend un logement 160 ou 260 qui accueille le module de détection 140 ou 240, qui est ainsi « intégré » au corps 150 ou 250, alors que dans le troisième mode, le dispositif de détection 300 comprend un module de détection 340, qui est monté sur la façade 104 d'un corps 350 du dispositif de détection 300.

Le corps 350 comprend plusieurs tranches 370, qui sont assemblées les unes aux autres suivant l'axe transversal Y100. Chaque tranche 370 comprend une borne d'entrée 110 reliée électriquement à une borne de sortie 120 par l'intermédiaire d'un membre conducteur 130 respectif. Chaque tranche 370 comprend une branche supérieure 352, une branche inférieure 354 et un conduit 356, dans lequel est ménagé un passage 358 recevant un membre conducteur 130 respectif. Chaque passage 358 débouche du corps 350 par un orifice 380 respectif, qui est ménagé dans une portion intermédiaire du conduit 356. Chaque orifice 380 présente ici une forme allongée, s'étendant parallèlement à l'axe de profondeur X100. Autrement dit, chaque orifice 380 débouche, d'une part, dans l'un des passages 358 et, d'autre part, sur la façade 104. Chaque élément conducteur 130 est ainsi accessible, depuis la façade 104, par l'intermédiaire d'un orifice 380 respectif.

Le module de détection 340 comprend un boitier 342, dans lequel est logé un circuit imprimé 344 avec un capteur 147. Le capteur 147 fonctionne de la même façon que dans les deux premiers modes de réalisation. Dans le troisième mode de réalisation, le capteur 147 est électriquement relié à chacun des membres conducteurs 130 par l'intermédiaire d'un élément conducteur 348 respectif. Dans l'exemple illustré, chaque élément conducteur 348 comprend une tige de métal, qui passe dans un orifice 380 respectif et vient au contact d'un membre conducteur 130 correspondant. Le module de détection 340 est par exemple maintenu en place grâce aux frottements des éléments conducteurs 348 sur des parois internes des orifices 380.

Le module de détection 340 du troisième mode est par exemple monté, au cours d'une opération de mise à niveau, dit aussi « *retrofit* » en anglais, sur un bornier comprenant un corps analogue au corps 350 mais initialement dépourvu de module de détection. À l'issue de l'opération de mise à niveau, le bornier devient un dispositif de détection 300, qui permet de surveiller la tension d'alimentation d'une charge critique et qui communique avec la passerelle 40.

Plus généralement, quel que soit le mode de réalisation, le dispositif de détection 100, 200 ou 300 permet de surveiller l'alimentation électrique d'une charge critique, tout en étant particulièrement pratique à monter dans un tableau électrique 2.

Dans le premier mode de réalisation, le corps 150 comprend deux tranches 170, tandis que dans les deuxième et troisième modes de réalisation, chacun des corps 250 ou 350 comprend quatre tranches 170 ou 370. Avantageusement, quel que soit le nombre de tranches 170 ou 370 du corps 150, 250 ou 350, un seul module de détection 140, 240 ou 340 est nécessaire au bon fonctionnement du dispositif de détection 100, 200 ou 300. Dans les deux premiers modes de réalisation, un seul module de détection 140 ou 240 est reçu dans le logement 160 ou 260 respectif.

Dans les trois modes de réalisation illustrés, le capteur 147 est configuré pour détecter la présence d'une tension non nulle entre les pôles d'alimentation 26A ou 26B.

En variante non représentée, le capteur 147 est configuré pour mesurer une ou des tensions associées aux pôles d'alimentation 26A ou 26B. Le capteur 147 est par exemple un voltmètre, auquel cas le module de détection 140, 240 ou 340 est configuré pour transmettre à la passerelle 40 un signal représentatif des valeurs mesurées, par exemple une valeur numérique.

D'autres méthodes sont bien entendu disponibles pour confirmer la présence d'une tension électrique associée aux pôles d'alimentation 26A ou 26B. Selon une autre variante non représentée, le capteur 147 est un capteur de courant, configuré pour détecter ou pour mesurer un courant, tel qu'un capteur de type Rogowski, aucun courant électrique ne circulant dans les membres conducteurs 130 si les pôles d'alimentation 26A ou 26B ne sont pas alimentés en énergie électrique.

Selon une autre variante non représentée, le capteur 147 comprend un capteur de température, configuré pour mesurer une température associée à chaque élément conducteur 130. Lors du passage du courant, les éléments conducteurs 130 s'échauffent par effet Joule. Un échauffement trop élevé peut indiquer un disfonctionnement du dispositif de détection 100, 200 ou 300, par exemple en cas de mauvaise connexion des bornes d'entrée 110 ou de sortie 120.

Toute caractéristique décrite pour un mode de réalisation ou une variante dans ce qui précède peut être mise en oeuvre pour les autres modes de réalisation et variantes décrits précédemment, pour autant que techniquement faisable.

## Revendications

1. Dispositif de détection de présence de tension (100 ; 200 ; 300) pour un tableau électrique (2), le dispositif de détection de présence de tension comprenant :
- des bornes d'entrée (110), chaque borne d'entrée étant configurée pour être électriquement connectée à un pôle d'alimentation (26A ; 26B) respectif d'une ligne d'alimentation (24A, 24B) du tableau électrique ;
- un capteur (147), configuré pour détecter une tension électrique associée aux pôles d'alimentation ; et
- un dispositif de communication (148), configuré pour envoyer une information reflétant la détection de la tension électrique effectuée par le capteur (147) à une passerelle (40) de communication vers un réseau informatique (42),
dans lequel le dispositif de détection de présence de tension (100 ; 200 ; 300) comprend en outre :
- des bornes de sortie (120), chaque borne de sortie étant configurée pour être électriquement connectée à un pôle de charge (27A ; 27B) respectif d'une charge électrique (25A ; 25B) ;
- des membres conducteurs (130), chaque membre conducteur connectant électriquement l'une des bornes d'entrée (110) à l'une des bornes de sortie (120) ; et
- une portion de fixation (102), par l'intermédiaire de laquelle le dispositif de détection de présence de tension est configuré pour être fixé sur le tableau électrique (2), par fixation de la portion de fixation sur un rail (22) de fixation appartenant au tableau électrique, et
- un module de détection de présence de tension (140 ; 240 ; 340), logeant le capteur (147) et le module de communication (148) ;
**caractérisé en ce que** le dispositif de détection de présence de tension (100 ; 200 ; 300) comprend en outre :
- un corps (150 ; 250 ; 350), qui présente une façade (104) qui est traversée par un axe de profondeur (X100) et qui est orthogonale à l'axe de profondeur, le corps comprenant :
∘ une branche supérieure (152 ;352), logeant les bornes d'entrée (110),
∘ une branche inférieure (154 ; 354), logeant les bornes de sortie (120), la branche supérieure et la branche inférieure étant traversées par un axe de hauteur (Z100) perpendiculaire à l'axe de profondeur (X100),
∘ un conduit (156 ; 356), qui relie la branche supérieure et la branche inférieure et ménage des passages (158 ; 358), chaque membre conducteur (130) reliant une des bornes d'entrée à la borne de sortie correspondante en étant logé respectivement dans l'un des passages (158 ; 350),
dans lequel, pour chaque passage (158 ; 358), le conduit (156 ; 356) ménage un orifice (180 ; 380) respectif qui est orienté parallèlement à l'axe de profondeur (X100) et par l'intermédiaire duquel ledit passage (158 ; 358) débouche du corps, le capteur (147) étant électriquement relié à chacun des membres conducteurs (130) par l'intermédiaire des orifices (180 ; 380).

2. Dispositif de détection de présence de tension (100 ; 200 ; 300) selon la revendication 1, dans lequel le corps (150 ; 250 ; 350) comprend plusieurs tranches (170 ; 370), qui sont assemblées en étant superposées suivant un axe transversal (Y100) perpendiculaire à l'axe de profondeur (X100) et à l'axe de hauteur (Z100), chaque tranche logeant l'une des bornes d'entrée (110), la borne de sortie (120) à laquelle la borne d'entrée est électriquement connectée, et le membre conducteur (130) connectant électriquement ladite borne d'entrée à ladite borne de sortie.

3. Dispositif de détection de présence de tension (100 ; 200) selon l'une quelconque des revendications 1 ou 2, dans lequel le conduit (156 ; 256), la branche supérieure (152) et la branche inférieure (154) délimitent un logement (160 ; 260), qui débouche en façade (104), et dans lequel le module de détection de présence de tension (140 ; 240) est reçu au moins en partie dans le logement (160 ; 260), de sorte que la branche supérieure (152), le module de détection de présence de tension (140 ; 240) et la branche inférieure (154) sont successivement répartis le long de l'axe de hauteur (Z100), le module de détection de présence de tension (140 ; 240) et la portion de fixation (102) étant disposés de part et d'autre du conduit (156 ; 256).

4. Dispositif de détection de présence de tension (300) selon l'une quelconque des revendications 1 ou 2, dans lequel le module de détection de présence de tension (340) est fixé sur la façade (104).

5. Dispositif de détection de présence de tension (100 ; 200 ; 300) selon l'une quelconque des revendications précédentes, dans lequel le capteur (147) est un capteur de tension, configuré pour détecter une tension électrique entre les pôles d'alimentation (26A, 26B), par l'intermédiaire des membres conducteurs (130).

6. Dispositif de détection de présence de tension (100 ; 200 ; 300) selon l'une quelconque des revendications précédentes, dans lequel le capteur (147) et le dispositif de communication (148) sont configurés pour être alimentés en énergie électrique par l'intermédiaire des membres conducteurs (130).

7. Dispositif de détection de présence de tension (100 ; 200 ; 300) selon l'une quelconque des revendications précédentes, dans lequel le dispositif de communication (148) comprend un émetteur radiofréquences (149), configuré pour envoyer une information reflétant la détection de la tension électrique effectuée par le capteur (147) à un récepteur radiofréquences de la passerelle (40).

8. Dispositif de détection de présence de tension (100 ; 200 ; 300) selon l'une quelconque des revendications précédentes, comprenant en outre au moins une carte de circuit imprimé (144), le capteur (147) et le dispositif de communication (148) étant formés par un ou plusieurs composants électroniques (146) disposés sur ladite au moins une carte de circuit imprimé.

9. Tableau électrique (2), comprenant :
- le dispositif de détection de présence de tension (100 ; 200 ; 300) selon l'une quelconque des revendications précédentes ;
- le rail (22), sur lequel le dispositif de détection de présence de tension est fixé au moyen de la portion de fixation (102) ;
- les pôles d'alimentation (26A ; 26B), auxquels les bornes d'entrées (110) sont respectivement connectées ;
- les pôles de charge (27A ; 27B) auxquels les bornes de sortie (120) sont respectivement connectées.

10. Tableau électrique (2) selon la revendication 9, dans lequel le tableau électrique comprend en outre la passerelle (40).

## Patentansprüche

1. Vorrichtung zur Erkennung der Präsenz von Spannung (100; 200; 300) für eine elektrische Schalttafel (2), wobei die Vorrichtung zur Erkennung der Präsenz von Spannung umfasst:
- Eingangsklemmen (110), wobei jede Eingangsklemme dazu ausgelegt ist, mit einem jeweiligen Versorgungspol (26A; 26B) einer Versorgungsleitung (24A, 24B) der elektrischen Schalttafel elektrisch verbunden zu sein;
- einen Sensor (147), der dazu ausgelegt ist, eine elektrische Spannung zu erkennen, die den Versorgungspolen zugeordnet ist; und
- eine Kommunikationsvorrichtung (148), die dazu ausgelegt ist, eine Information, die die von dem Sensor (147) durchgeführte Erkennung der elektrischen Spannung widerspiegelt, über ein Kommunikations-Gateway (40) an ein IT-Netzwerk (42) zu schicken,
wobei die Vorrichtung zur Erkennung der Präsenz von Spannung (100; 200; 300) ferner umfasst:
- Ausgangsklemmen (120), wobei jede Ausgangsklemme dazu ausgelegt ist, mit einem jeweiligen Ladepol (27A; 27B) einer elektrischen Ladung (25A; 25B) elektrisch verbunden zu sein;
- leitende Elemente (130), wobei jedes leitende Element eine der Eingangsklemmen (110) mit einer der Ausgangsklemmen (120) elektrisch verbindet; und
- einen Befestigungsabschnitt (102), über den die Vorrichtung zur Erkennung der Präsenz von Spannung dazu ausgelegt ist, auf der elektrischen Schalttafel (2) durch Befestigung des Befestigungsabschnitts auf einer Befestigungsschiene (22) befestigt zu sein, die zu der elektrischen Schalttafel gehört, und
- ein Modul zur Erkennung der Präsenz von Spannung (140; 240; 340), das den Sensor (147) und das Kommunikationsmodul (148) aufnimmt;
**dadurch gekennzeichnet, dass** die Vorrichtung zur Erkennung der Präsenz von Spannung (100; 200; 300) ferner umfasst:
- einen Körper (150; 250; 350), der eine Vorderseite (104) aufweist, die von einer Tiefenachse (X100) durchquert wird und die zu der Tiefenachse orthogonal ist, wobei der Körper umfasst:
• einen oberen Schenkel (152; 352), der die Eingangsklemmen (110) aufnimmt,
• einen unteren Schenkel (154; 354), der die Ausgangsklemmen (120) aufnimmt, wobei der obere Schenkel und der untere Schenkel von einer Höhenachse (Z100) durchquert werden, die senkrecht zu der Tiefenachse (X100) ist,
• eine Führung (156; 356), die den oberen Schenkel und den unteren Schenkel verbindet und Durchgänge (158; 358) ausbildet, wobei jedes leitende Element (130) eine der Eingangsklemmen mit der entsprechenden Ausgangsklemme verbindet, indem es jeweils in einem der Durchgänge (158; 350) untergebracht ist,
wobei für jeden Durchgang (158; 358) die Führung (156; 356) eine jeweilige Öffnung (180; 380) ausbildet, die parallel zur Tiefenachse (X100) ausgerichtet ist und über die der Durchgang (158; 358) aus dem Körper ausmündet, wobei der Sensor (147) mit jedem der leitenden Elemente (130) über Öffnungen (180; 380) elektrisch verbunden ist.

2. Vorrichtung zur Erkennung der Präsenz von Spannung (100; 200; 300) nach Anspruch 1, wobei der Körper (150; 250; 350) mehrere Scheiben (170; 370) umfasst, die verbunden sind, indem sie gemäß einer transversalen Achse (Y100) senkrecht zur Tiefenachse (X100) und zur Höhenachse (Z100) zusammengebaut sind, wobei jede Scheibe eine der Eingangsklemmen (110) aufnimmt, wobei die Ausgangsklemme (120), mit der die Eingangsklemme elektrisch verbunden ist, und das leitende Element (130) die Eingangsklemme mit der Ausgangsklemme elektrisch verbindet.

3. Vorrichtung zur Erkennung der Präsenz von Spannung (100; 200) nach einem der Ansprüche 1 oder 2, wobei die Führung (156; 256), der obere Schenkel (152) und der untere Schenkel (154) eine Aufnahme (160; 260) begrenzen, die an der Vorderseite (104) ausmündet, und wobei das Modul zur Erkennung der Präsenz von Spannung (140; 240) mindestens teilweise in der Aufnahme (160; 260) derart aufgenommen ist, dass der obere Schenkel (152), das Modul zur Erkennung der Präsenz von Spannung (140; 240) und der untere Schenkel (154) nacheinander entlang der Höhenachse (Z100) verteilt sind, wobei das Modul zur Erkennung der Präsenz von Spannung (140; 240) und der Befestigungsabschnitt (102) beiderseits der Führung (156; 256) angeordnet sind.

4. Vorrichtung zur Erkennung der Präsenz von Spannung (300) nach einem der Ansprüche 1 oder 2, wobei das Modul zur Erkennung der Präsenz von Spannung (340) auf der Vorderseite (104) befestigt ist.

5. Vorrichtung zur Erkennung der Präsenz von Spannung (100; 200; 300) nach einem der vorangehenden Ansprüche, wobei der Sensor (147) ein Spannungssensor ist, der dazu ausgelegt ist, zwischen den Versorgungspolen (26A, 26B) über die leitenden Elemente (130) eine elektrische Spannung zu erkennen.

6. Vorrichtung zur Erkennung der Präsenz von Spannung (100; 200; 300) nach einem der vorangehenden Ansprüche, wobei der Sensor (147) und die Kommunikationsvorrichtung (148) dazu ausgelegt sind, über die leitenden Elemente (130) mit elektrischer Energie versorgt zu werden.

7. Vorrichtung zur Erkennung der Präsenz von Spannung (100; 200; 300) nach einem der vorangehenden Ansprüche, wobei die Kommunikationsvorrichtung (148) einen Funkfrequenzsender (149) umfasst, der dazu ausgelegt ist, eine Information, die die von dem Sensor (147) durchgeführte Erkennung der elektrische Spannung widerspiegelt, an einen Funkfrequenzempfänger des Gateways (40) zu senden.

8. Vorrichtung zur Erkennung der Präsenz von Spannung (100; 200; 300) nach einem der vorangehenden Ansprüche, umfassend ferner mindestens eine gedruckte Leiterplatte (144), wobei der Sensor (147) und die Kommunikationsvorrichtung (148) von einer oder mehreren elektronischen Komponenten (146) gebildet sind, die auf der mindestens einen gedruckten Leiterplatte angeordnet sind.

9. Elektrische Schalttafel (2), umfassend:
- die Vorrichtung zur Erkennung der Präsenz von Spannung (100; 200; 300) nach einem der vorangehenden Ansprüche;
- die Schiene (22), auf der die Vorrichtung zur Erkennung der Präsenz von Spannung mittels des Befestigungsabschnitts (102) befestigt ist;
- die Versorgungspole (26A; 26B), mit denen die Eingangsklemmen (110) jeweils verbunden sind;
- die Ladepole (27A; 27B), mit denen die Ausgangsklemmen (120) jeweils verbunden sind.

10. Elektrische Schalttafel (2) nach Anspruch 9, wobei die elektrische Schalttafel ferner den Gateway (40) umfasst.

## Claims

1. A device for detecting the presence of voltage (100; 200; 300) for an electrical panel (2), the device for detecting the presence of voltage comprising:
- input terminals (110), each input terminal being configured to be electrically connected to a respective power supply pole (26A; 26B) of a power supply line (24A, 24B) of the electrical panel;
- a sensor (147), configured to detect an electrical voltage associated with the power supply poles; and
- a communication device (148), configured to send information reflecting the detection of the electrical voltage done by the sensor (147) at a communication gateway (40) to a computer network (42),
wherein the device for detecting the presence of voltage (100; 200; 300) further comprises:
- output terminals (120), each output terminal being configured to be electrically connected to a respective load pole (27A; 27B) of an electrical load (25A; 25B);
- conductive members (130), each conductive member electrically connecting one of the input terminals (110) to one of the output terminals (120); and
- an attachment portion (102), by means of which the device for detecting the presence of voltage is configured to be attached to the electrical panel (2), by attaching the attachment portion on an attachment rail (22) belonging to the electrical panel, and
- a module for detecting the presence of voltage (140; 240; 340), housing the sensor (147) and the communication module (148);
**characterized in that** the device for detecting the presence of voltage (100; 200; 300) further comprises:
- a body (150; 250; 350), which has a façade (104) that is passed through by a depth axis (X100) and which is orthogonal to the depth axis, the body comprising:
∘ an upper branch (152; 352), housing the input terminals (110),
∘ a lower branch (154; 354), housing the output terminals (120), the upper branch and the lower branch being passed through by a height axis (Z100) perpendicular to the depth axis (X100),
∘ a duct (156; 356), which connects the upper branch and the lower branch and forms passages (158; 358), each conductive member (130) connecting one of the input terminals to the corresponding output terminal while being housed respectively in one of the passages (158; 350),
wherein, for each passage (158; 358), the duct (156; 356) forms a respective orifice (180; 380) that is oriented parallel to the depth axis (X100) and by means of which said passage (158; 358) opens from the body, the sensor (147) being electrically connected to each of the conductive members (130) by means of the orifices (180; 380).

2. The device for detecting the presence of voltage (100; 200; 300) according to claim 1, wherein the body (150; 250; 350) comprises several edge faces (170; 370), which are assembled while being superimposed along a transverse axis (Y100) perpendicular to the depth axis (X100) and the height axis (Z100), each edge face housing one of the input terminals (110), the output terminal (120) to which the input terminal is electrically connected, and the conductive member (130) electrically connecting said input terminal to said output terminal.

3. The device for detecting the presence of voltage (100; 200) according to any one of claims 1 or 2, wherein the duct (156; 256), the upper branch (152) and the lower branch (154) delimit a housing (160; 260), which opens on the façade (104), and wherein the module for detecting the presence of voltage (140; 240) is received at least in part in the housing (160; 260), such that the upper branch (152), the module for detecting the presence of voltage (140; 240) and the lower branch (154) are successively distributed along the height axis (Z100), the module for detecting the presence of voltage (140; 240) and the attachment portion (120) being arranged on either side of the duct (156; 256).

4. The device for detecting the presence of voltage (300) according to any one of claims 1 or 2, wherein the module for detecting the presence of voltage (340) is attached on the façade (104).

5. The device for detecting the presence of voltage (100; 200; 300) according to any one of the preceding claims, wherein the sensor (147) is a voltage sensor, configured to detect an electrical voltage between the power supply poles (26A, 26B), by means of the conductive members (130).

6. The device for detecting the presence of voltage (100; 200; 300) according to any one of the preceding claims, wherein the sensor (147) and the communication device (148) are configured to be supplied with electrical energy by means of the conductive members (130).

7. The device for detecting the presence of voltage (100; 200; 300) according to any one of the preceding claims, wherein the communication device (148) comprises a radiofrequency transmitter (149), configured to send information reflecting the detection of electrical voltage done by the sensor (147) to a radiofrequency receiver of the gateway (40).

8. The device for detecting the presence of voltage (100; 200; 300) according to any one of the preceding claims, further comprising at least one printed circuit board (144), the sensor (147) and the communication device (148) being formed by one or several electronic components (146) arranged on said at least one printed circuit board.

9. An electrical panel (2), comprising:
- the device for detecting the presence of voltage (100; 200; 300) according to any one of the preceding claims;
- the rail (22), on which the device for detecting the presence of voltage is attached using the attachment portion (102);
- the power supply poles (26A; 26B), to which the input terminals (110) are respectively connected;
- the load poles (27A; 27B), to which the output terminals (120) are respectively connected.

10. The electrical panel (2) according to claim 9, wherein the electrical panel further comprises the gateway (40).
